# EUROPÄISCHE PATENTANMELDUNG

(11) **EP 3 623 617 A1**
(43) Veröffentlichungstag der Anmeldung: **18.03.2020**
(21) Anmeldenummer: 18194196.4
(22) Anmeldetag: 13.09.2018
(51) Int. Cl.: F03D 80/30, F03D 17/00, G01R 31/28, H02G 13/00, G01R 31/02

(54) **VORRICHTUNG, SYSTEM UND VERFAHREN ZUR MESSUNG EINES BLITZSCHUTZES FÜR WINDENERGIEANLAGEN**

(71) Anmelder: KRAMPE, Nina Katharina, 48151 Münster (DE); KRAMPE, Timothy, 48151 Münster (DE)
(72) Erfinder: KRAMPE, Nina Katharina, 48151 Münster (DE); KRAMPE, Timothy, 48151 Münster (DE)
(74) Vertreter: Winter, Brandl, Fürniss, Hübner, Röss, Kaiser, Polte - Partnerschaft mbB

(57) **Zusammenfassung**

Es sind Verfahren, Systeme und Vorrichtungen zum Testen der Blitzschutzsicherheit von Windenergieanlagen beschrieben, die eine zuverlässige Überprüfung der Blitzschutzsicherheit erlauben.

## Beschreibung

Aus der DE 10 2012 214 981 A1 ist eine Blitzableitvorrichtung für eine Windturbine bekannt, die zwei Leiter in redundanter Ausbildung umfasst. Hierdurch kann bei Ausfall eines der Leiter der Blitzstrom noch über den anderen Leiter übertragen werden. Dies erfordert allerdings einen höheren vorrichtungstechnischen Aufwand.

In der DE 10 2012 009 205 A1 ist eine Blitzstromüberwachungsvorrichtung beschrieben, die eine Energieversorgungs- und Sensoreinrichtung aufweist, die aus einer auf die zu überwachende Anlage einwirkenden Blitzentladung Energie für eine Wandlereinrichtung bezieht. Die kombinierte Energieversorgungs- und Sensoreinrichtung kann aus der bezogenen Blitzenergie ein optisches Signal generieren. Die Blitzstromüberwachungsvorrichtung ist somit auf einwirkende Blitzerscheinungen gerichtet.

Der Erfindung liegt die Aufgabe zugrunde, die Blitzschutzwirksamkeit einer bereits vorhandenen oder neu installierten oder reparierten Blitzschutzeinrichtung, insbesondere einer Windenergieanlage oder einer anderen Anlage oder blitzgefährdeten Komponente effektiv und/oder mit geringem Aufwand testen oder messen zu können.

Diese Aufgabe wird durch eine Vorrichtung gemäß Patentanspruch 1 oder einem oder mehreren der Vorrichtungs-Unteransprüche gelöst. Weiterhin wird ein Verfahren gemäß dem unabhängigen Verfahrensanspruch, und/oder den Verfahrens-Unteransprüchen geschaffen. Ferner wird ein Blitzschutzsystem bereitgestellt, dessen Funktionsfähigkeit bei Blitzeinwirkungen zuverlässig beurteilt werden kann.

Bei einigen Ausführungsbeispielen ist es nicht erforderlich, dass im Rotorblatt-Inneren vorhandene Schutzeinrichtungen oder schützende leitende Komponenten wie etwa Schutzleiter freigelegt und in freigelegtem Zustand untersucht werden müssen. Selbstverständlich ist es gleichwohl möglich, leitende Komponenten für die Blitzführung oder sonstige Stromführung freizulegen und in freigelegtem Zustand zu untersuchen.

Die Erfindung wird nachfolgend unter Bezugnahme auf die anliegenden Zeichnungen näher beschrieben. Hierbei sind Ausführungsbeispiele mit einzelnen Ausgestaltungen erläutert. Die Ausgestaltungen können jeweils in beliebiger Weise mit einander kombiniert werden oder auch einzeln jeweils für sich als eigenständige Ausführungsbeispiele implementiert sein.
Figur 1 zeigt eine geschnittene Seitenansicht eines Rotorblattes 1 einer Windenergieanlage.
Figur 2 illustriert eine Gestaltung eines Blitzableiters, der im Inneren des Rotorblattes untergebracht sein kann und Unterbrechungen aufweist.
Figur 3 veranschaulicht ein Ausführungsbeispiel der elektrischen Ausgestaltung der Ausführungsbeispiele gemäß Figur 1 oder 2 mit Energiegenerator und Energiemessungskomponenten.
Figur 4 zeigt ein weiteres Ausführungsbeispiel der elektrischen Komponenten für den Blitzschutztest, wobei die elektrische Erregung in Form einer kurzzeitigen Hochspannung oder eines kurzzeitigen hohen Stroms oder einer hohen kurzzeitigen Leistungszuführung erfolgt.
Figur 5 zeigt ein abgeändertes Ausführungsbeispiel einer Blitzschutzeinrichtung für ein Rotorblatt 31 einer Windenergieanlage, das ähnlich aufgebaut ist wie die Blitzschutzsicherung gemäß den vorstehend beschriebenen Ausführungsbeispielen gemäß den Figuren 1-4, allerdings die nachstehend erläuterten Abweichungen oder Umgestaltungen aufweisen kann, die bei den Ausführungsbeispielen der Figuren 1-4 ganz oder teilweise ebenfalls realisiert werden können, wodurch zusätzliche Ausführungsbeispiele geschaffen sind.

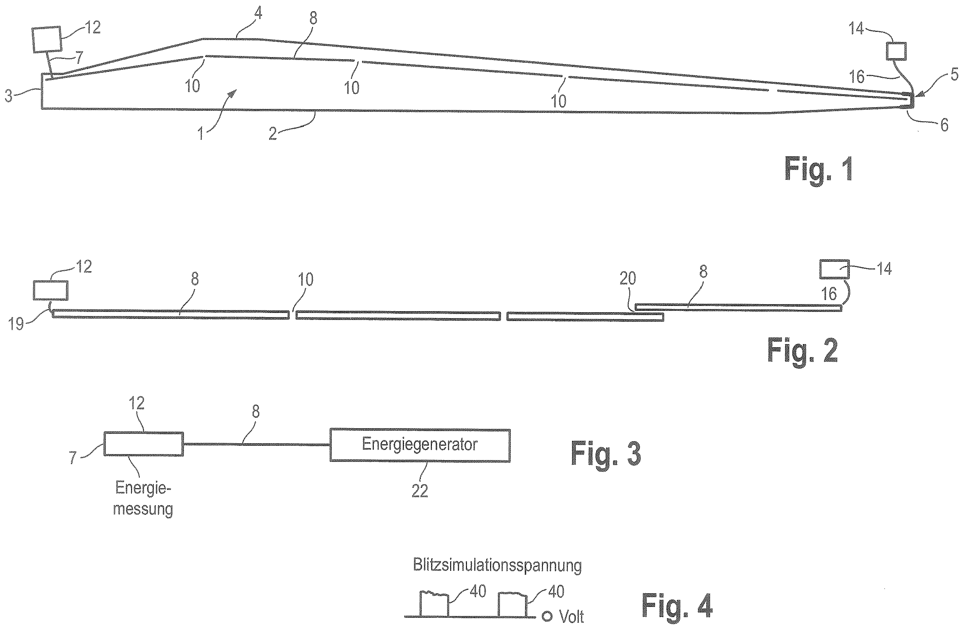

In Figur 1 ist ein Rotorblatt dargestellt, das eine Rotorblattspitze 5 an einem Ende und einen Rotorblattanschluss 3 am gegenüber liegenden Ende aufweist. Über den Rotorblattanschluss 3 ist das Rotorblatt 1 an der auf dem nicht dargestellten Turm der Windenergieanlage montierten Gondel angebracht. Am Fuß des Turms kann eine Trafostation angebracht sein, die über Kabel oder Leitungen mit der Gondel und den Rotorblättern verbunden sein kann, um die durch die Winddrehung erzeugte elektrische Energie aufzunehmen oder weiter zu leiten. Diese oder auch andere oder weitere Komponenten der Windenergieanlage sind beim dargestellten Ausführungsbeispiel gegenüber negativen Auswirkungen von Blitzeinschlägen gesichert.

Die Rotorblattspitze 5 kann als Metallkappe oder in anderer Form elektrisch leitend ausgebildet sein, so dass eine Blitzeinschlaggefahr hier erhöht ist und die eventuellen Blitzeinschläge somit geführt werden können. Bei dem in Figur 1 gezeigten Ausführungsbeispiel ist die Rotorblattoberseite 4 durch nicht leitendes Material gebildet oder beschichtet, so dass die Blitzeinschlaggefahr auf die Rotorblattspitze 5 fokussiert ist. Die Rotorblattspitze 5 ist durch einen intern im Rotorblatt geführten Blitzableiter 8 elektrisch kontaktiert, der völlig elektrisch leitend durchgehend ausgebildet sein kann, jedoch auch altersbedingt oder aufgrund von Verbiegungskräften eine oder mehrere Unterbrechungen 10 aufweisen kann, so dass die Stromleitung und Energieführung nachteilig beeinträchtigt oder sogar ganz unterbrochen sein kann. Damit wäre der Blitzschutz erheblich eingeschränkt. Solche Störungen lassen sich bei Ausführungsformen der Erfindungen erkennen.

Auf der der Rotorblattoberseite 4 gemäß Figur 1 gegenüber liegenden Blattunterseite 2 des Rotorblattes 1 ist ebenfalls eine Blattbeschichtung vorgesehen, so dass auch die Blattunterseite 2 geschützt ist.

An der der Rotorblattspitze 5 am anderen Rotorblattende gegenüber liegenden Rotorblatt-Anschlussseite 3 ist eine Messeinrichtung 12 vorgesehen, die über einen Anschluss 7 für eine Blitzstrom- oder Blitzspannungs-Messung vorgesehen ist und diese Messung durchführt. Die Messeinrichtung 12 misst die Stärke des elektrischen Stroms oder der elektrischen Spannung oder der elektrischen Leistung oder der Impedanz oder des Widerstandes, so dass die Funktionsfähigkeit und Schutzwirkung gegen Blitzeinschläge gut überprüft werden kann.

An der Rotorblattspitze 5 ist ein Generator 14 zur Erzeugung von elektrischen Spannungen oder Strömen vorgesehen oder mit der Rotorblattspitze elektrisch verbunden, um kurzzeitige Blitzeinschläge simulieren zu können. Zur Zuführung des Stroms oder der Spannung ist eine Leitung 16 vorgesehen, die mit der Kappe 5 oder in die Rotorblattspitze eingeführten Leitungen zur Zuführung von Strom und/oder Spannung für die Blitzsimulation verbunden sein kann.

Über die Messeinrichtung 12 kann die Qualität der Blitzenergieableitung und damit des Blitzschutzes gut bestimmt werden, so dass auch Versicherungen die Gefahr von Beschädigungen aufgrund eines Blitzeinschlages gut bewerten können.

In Figur 2 ist eine Ausgestaltung eines Systems zur Strom- und/oder Spannungsführung im Inneren eines Rotorblattes 1 dargestellt. Der in Figur 2 gezeigte Blitzableiter 8 weist eine oder mehrere Unterbrechungen 10 auf, die sich als Funkenbrücken oder Funkenstrecken bei Blitzeinschlägen oder sonstigen Zuführungen von starken Spannungen oder Strömen bemerkbar machen können. Bei der Ausgestaltung gemäß Figur 2 besteht der Blitzableiter 8 aus mehreren Teilen, die sich auf der rechten Seite über einander geschoben haben können, beispielsweise planmäßig oder aufgrund von betriebsbedingten Verwerfungen oder Verbiegungen.

Gemäß Figur 2 ist am rechten Ende des Blitzableiters 8 der Blitzenergiegenerator 14 zur Simulation eines Blitzeinschlages oder einer hierbei auftretenden Blitzenergie angebracht. Die Zuführung oder Leitung zur Führung der einen Blitzeinschlag simulierenden Energie ist durch die Leitung 16 signalisiert.

Bei dem Ausführungsbeispiel gemäß Figur 3 sind elektrische Komponenten gezeigt, die einen Energiegenerator 22 in Form einer Batterie oder eines Stromgenerators oder einer sonstigen Leistungsquelle aufweisen können. Die Messeinrichtung zur Messung des Stroms oder Spannung oder sonstigen elektrischen Leistung ist durch die Messeinrichtung 12 gebildet. Die Messeinrichtung 12 zur Energiemessung oder Strom- oder Spannungsmessung kann, wie zum Beispiel in Figur 4 gezeigt, durch den Energiegenerator 22 mit kurzzeitigen, beispielsweise impulsförmigen Strom- oder Spannungsspitzen beaufschlagt werden, so dass Blitze simuliert werden können. Die Strom- oder Spannungsbeaufschlagungen können beispielsweise Breiten von 5 Sekunden oder weniger, vorzugsweise von 1 Sekunde oder weniger aufweisen. Die Stärke der vom Energiegenerator 22 erzeugten, einen Blitzeinschlag simulierenden Spannungen kann beispielsweise 30.000 Volt betragen, die vom Generator 14 generiert werden, jedoch auch deutlich höher oder deutlich niedriger liegen, beispielsweise zwischen 100 Volt bis unter 1.000 kV. Auch oder alternativ können die vom Generator 14 generierten Ströme für die Blitzsimulation zwischen 1 Ampere bis 100.000 Ampere, beispielsweise 30 kA liegen. Die tatsächlichen Stromstärken, Spannungen oder Leistungen können abhängig von der Größe oder der Menge der Rotorblätter und somit abhängig von der Blitzeinschlagsgefahr festgelegt und über den Generator 14 eingestellt werden.

Die Messeinrichtung 12 weist vorzugsweise einen Speicher zur Speicherung der Messergebnisse, d.h. der gemessenen Ströme oder Spannungen und des zeitlichen Verlaufs der gemessenen Ströme, Spannungen oder Leistungen auf, so dass die Blitzschutzqualität dauerhaft überprüft werden kann.

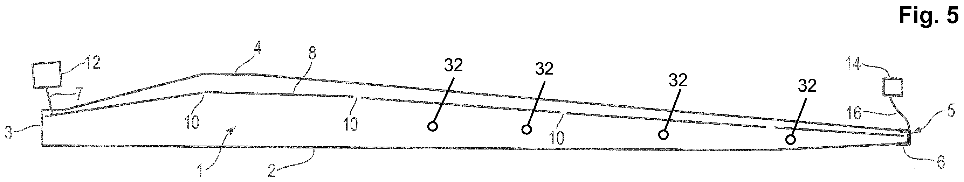

Bei dem in Figur 5 gezeigten Ausführungsbeispiel ist die Messeinrichtung 12 an dem Rotorblattende 3 vorgesehen, während der Generator 14 an der Rotorblattspitze 5 des Rotorblatts 1, das in Figur 5 mit dem Bezugszeichen 31 bezeichnet ist, angeordnet ist beziehungsweise auf diese einwirkt, beispielsweise durch eine elektrisch leitende Verbindung oder durch einen entsprechenden Spannungsüberschlag.

Es ist bei den dargestellten Ausführungsbeispielen oder auch abgeänderten Ausführungsformen möglich, den Energiegenerator 14 oben in der Gondel der Windenergieanlage anzubringen, sodass er hierdurch getragen werden kann. Die Verbindung des Generators 14 kann über die Leitung 16 oder in geeigneter anderer Form auf die Rotorblattspitze einwirken oder durch einen echten oder simulierten Blitzüberschlag geführt werden. Die Kabellänge des Verbindungskabels 16 ist entsprechend dem Abstand zwischen der Rotorblattspitze und dem Generator 14 gewählt oder festlegbar.

Zur Verbindung der Messeinrichtung 12 und dem Rotorblattanschluss 3 über die Leitung 7 kann eine oder mehrere elektrische Leitung(en) vorgesehen sein. Alternativ oder zusätzlich können auch Bürsten oder Borsten vorgesehen sein, die die Messeinrichtung 12 mit dem Rotorblattanschluss und dem Oberseitenbereich des Rotorblatts elektrisch in flexibler verformbarer und damit gut an der Rotorblattoberseite anliegender Form verbinden können. Es können eine, zwei oder drei oder viele von diesen elektrisch leitenden Verbindungselementen wie etwa Bürsten oder Borsten oder leitenden Bürsten- oder Borstenhaaren vorgesehen sein, sodass eine gute, nicht beschädigende Verbindung zwischen dem Rotorblatt und der Messeinrichtung 12 erreicht werden kann.

Die Messeinrichtung 12 kann nicht nur links, wie im Ausführungsbeispiel gemäß den Figuren gezeigt, vorgesehen sein, sondern auch rechts, das heißt an der Blattspitze 5 oder in vielen wählbaren Zwischenpositionen angeordnet sein.

Beim Ausführungsbeispiel gemäß Figur 5 sind am Rotorblatt 31 ein oder mehrere Rezeptoren 32 vorgesehen, die eine Aufnahme und Einleitung einer Energie, beispielsweise einer Blitzenergie oder Blitzsimulationsenergie oder Testenergie ermöglichen. Hierzu können diese an der seitlichen Blattaußenseite vorgesehenen Rezeptoren beispielsweise durch elektrisch leitende Komponenten wie etwa Metallblättchen realisiert sein. Es können, wie in Figur 5 gezeigt ist, beispielsweise vier oder auch mehr oder weniger Rezeptoren in unterschiedlichen Positionen wie dargestellt oder je nach Einsatzzweck geeignet erscheinenden Positionen realisiert sein.

Der Generator 14 oder auch der Generator 22, der in Figur 2 oder 3 dargestellt ist, kann vorzugsweise hohe Spannungswerte von mehr als 100V oder 1000V generieren, vorteilhaft bis zu 30.000V oder mehr, beispielsweise 60kV oder mehr generieren.

Bei abgeänderten Ausführungsbeispielen ist die Positionierung des Generators 14 und der Messeinrichtung 12 vertauschbar, sodass der Generator die Blitzenergie an der Blattwurzel 3 einspeist und die Messeinrichtung 12 an der Blattspitze 5 vorgesehen oder über ein elektrisches Kabel oder in sonstiger Weise elektrisch verbunden ist.

Die Kabellänge des Kabels, beispielsweise 16, das an der Blattspitze angebracht ist, kann in geeigneter Form variiert werden, sodass gewährleistet ist, dass die Spannungsführung über die Leitung 16 nicht gestört oder unterbrochen wird.

Die vorstehend beschriebenen Merkmale und Ausführungsbeispiele können in beliebiger Weise frei zusammengefasst werden oder in beliebiger Weise miteinander kombiniert werden, wodurch sich jeweils weitere eigenständige Ausführungsbeispiele ergeben.

Gegenstand der vorliegenden Erfindung ist auch ein Verfahren zur Messung des Blitzschutzes von Windenergieanlagen, bei dem ein Rotor, beispielsweise eine Rotorblattspitze mit elektrischem Strom oder elektrischer Spannung oder Leistung gezielt gespeist wird und die an einem Rotorblattanschluss hierbei auftretende Spannung, Leistung oder der Strom gemessen wird, so dass aus einem Vergleich zwischen der eingespeisten Energie (Strom, Spannung oder Leistung) und der am anderen Ende des Rotorblattes, beispielsweise des Rotorblattanschlusses gemessenen Energie die Qualität des Blitzschutzes gegenüber Blitzeinschlägen ermittelt und beurteilt werden kann und eventuelle Austauschvorgänge oder Korrektureingriffe festgelegt werden können.

## Patentansprüche

1. Vorrichtung zur Messung oder Testung eines Blitzschutzes einer Windenergieanlage, die ein oder mehrere drehbare Rotorblätter (1, 31) ausweist, wobei ein oder mehrere elektrisch leitende Blitzableiter (8) an oder vorzugsweise in einem Rotorblatt angebracht sind, mit einem Generator (14, 22), der an einer Rotorblattspitze (5) oder einer anderen Komponente wie etwa einer Gondel anbringbar oder in elektrischen Kontakt mit dem Blitzableiter (8) an oder im Inneren des Rotorblattes bringbar ist, und mit einer Messeinrichtung (12), die an einem anderen Ende oder Teil des Blitzableiters (8) angebracht oder mit diesem in elektrische Verbindung bringbar ist.

2. Vorrichtung nach Anspruch 1, wobei eine Rotorblattoberseite (4) mit elektrisch nicht leitendem Überzug oder Material versehen ist.

3. Vorrichtung nach Anspruch 1 oder 2, wobei die Rotorblattspitze (5) elektrisch leitend ist und einen durch einen Blitzeinschlag hervorgerufenen Strom leiten und zu dem elektrisch innen liegenden Blitzableiter (8) des Rotorblattes (1) führen kann.

4. Vorrichtung nach einem der vorhergehenden Ansprüche, wobei der Blitzableiter (8) aus elektrisch leitendem Material besteht, vorzugsweise aus Aluminium.

5. Vorrichtung nach einem der vorhergehenden Ansprüche, bei dem der Blitzableiter (8) aus einem Metallprofil besteht, das einen rechteckförmigen Querschnitt aufweisen kann und mit einer Rotorblattspitze (5) elektrisch verbunden sein kann oder ist.

6. Vorrichtung nach einem der vorhergehenden Ansprüche, wobei die Rotorblattspitze (5) als Kappe (6) ausgebildet ist.

7. Vorrichtung nach einem der vorhergehenden Ansprüche, **dadurch gekennzeichnet, dass** das Rotorblatt (1) einen Anschluss (3) für den Anschluss des Rotorblattes aufweist, der an einer Gondel der Windenergieanlage anbringbar ist.

8. Vorrichtung nach einem der vorhergehenden Ansprüche, mit einem oder mehreren vorzugsweise elektrisch leitenden Rezeptoren (32), die an dem Rotorblatt (1, 31) angeordnet oder anbringbar sind.

9. Vorrichtung nach einem der vorhergehenden Ansprüche, mit einer oder vorzugsweise mehreren Bürsten oder Borsten zur Spannungs- und/oder Stromleitung zur Messeinrichtung (12).

10. Verfahren zur Messung der Blitzenergiesicherheit einer Windenergieanlage, wobei ein Rotor mit einem Blitzenergiegenerator (14) in Verbindung ist oder gebracht wird, und der Strom, die Spannung, die Leistung und/oder der Widerstand an einem Anschluss eines Blitzableiters (8) messbar ist, und optional eine Vorrichtung gemäß einem der Ansprüche 1-9 benutzt wird.

11. Verfahren nach Anspruch 10, bei dem die zur Blitzsimulation zugeführte elektrische Energie vom Energiegenerator (14) zur Energiemessung (12) auf Stromwerte zwischen 10 A und 10 kA und/oder Spannungswerte zwischen 10V und 1.000 kV beschränkt ist.

12. Blitzschutzsystem, das eine Vorrichtung gemäß einem der Ansprüche 1-9 aufweist und zur Durchführung des Verfahrens gemäß Anspruch 10 oder 11 ausgelegt ist.
